Europäisches Patentamt

European Patent Office

Office européen des brevets

(11) Publication number: **0 529 756 A1**

# EUROPEAN PATENT APPLICATION

(21) Application number: **92300614.2**

(22) Date of filing: **24.01.92**

(51) Int. Cl.5: **G01R 11/57**

(30) Priority: **30.08.91 US 752303**

(43) Date of publication of application:
**03.03.93 Bulletin 93/09**

(84) Designated Contracting States:
**CH DE FR GB LI**

(71) Applicant: **GENERAL ELECTRIC COMPANY**
**1 River Road**
**Schenectady, NY 12345(US)**

(72) Inventor: **Chen, Heng-Chun David**
**294 Forest Park**
**Durham, New Hampshire 03824(US)**
Inventor: **Bullock, Donald Frank**
**P.O. Box 202**
**Somersworth, New Hampshire 03878(US)**

(74) Representative: **Pratt, Richard Wilson et al**
**London Patent Operation G.E. Technical**
**Services Co. Inc. Essex House 12/13 Essex**
**Street**
**London WC2R 3AA (GB)**

(54) Method and apparatus for converting a meter register constant.

(57) The present invention, in one embodiment, is a method comprising the steps of representing a meter constant as a ratio of two integers, at least one of the integers being derived, at least in part, by a meter constant $C_z$, and using the ratio to derive a meter measurement of a quantum of energy consumed.

```
100 ──┐                    ┌102
       ▼                    ▼
┌────────────────────────────┐
│    INPUT FROM METER        │
└────────────────────────────┘
              │         ┌104
              ▼
┌────────────────────────────┐
│    PULSE ACCUMULATOR        │
└────────────────────────────┘
              │              ┌108
              ▼                  106
┌────────────────────────────┐
│      INTERNATIONAL          │
│   CONFIGURATION LAYER       │
├────────────────────────────┤
│    METER CALCULATIONS       │──110
│         LAYER               │
└────────────────────────────┘
              │         ┌112
              ▼
┌────────────────────────────┐
│     DISPLAY OUTPUT          │
└────────────────────────────┘
```

*FIG. 1*

EP 0 529 756 A1

## I. Background of the Invention

### A. Field of the Invention

The present invention relates to energy meters, and more particularly, relates to converting a meter register for the domestic U.S. market to a meter register compatible with international market requirements.

### B. Related Art

Meter registers manufactured for the domestic U.S. market typically utilize, for generating energy measures, a meter constant defined as the total kilowatt-hour (kWh) per pulse. More particularly, energy consumption is measured by tracking pulse counts indicative of energy consumed. One pulse is generated, for example, for each rotation of a disk. The disk rotates at a rate proportional to energy consumed. By multiplying the total pulse count by the meter constant, a kWh measure is provided.

In the international market, however, a different meter constant $C_z$ is utilized. In order to be compatible with meters for the international marketplace, it is necessary to provide a mechanism for dealing with this difference in meter constant definition. Accuracy, however, must be retained.

## II. Summary of the Invention

The present invention, in one embodiment, is a software layer built over the other software layers of a meter register. In the present software layer, compensation and/or changes are made in order to accommodate international definitions and requirement. The algorithm embedded in the software layer provides for conversion of meter measurements made by an international meter to domestic U.S. form. Using the converted measurements, the register functions to perform other operations which provide various measures of energy consumption.

The present invention eliminates a need to entirely reprogram a meter register manufactured for the U.S. domestic market in order to utilize the register in an international context.

## III. Brief Description of the Drawings

These and other objects of the present invention, together with further features and advantages thereof, will become apparent from the following detailed specification when read together with the accompanying drawings, in which:

Figure 1 is a block diagram description of a meter register including the present invention; and

Figure 2 is a flow chart illustrating a sequence of process steps in accordance with one aspect of the present invention.

## IV. Detailed Description of the Drawings

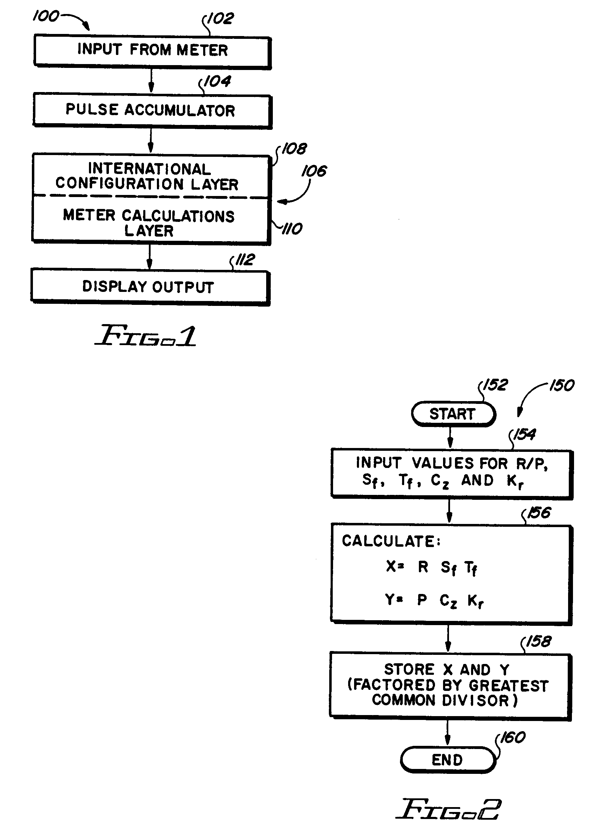

Referring now to Figure 1, a block diagram description 100 of a meter register is provided. Input from a meter is provided as illustrated at block 102. The input may be in one of many forms including, for example, pulses generated from a rotating disk. Such pulse generation is well-known in the art.

The pulses are accumulated in a pulse accumulator 104 which simply counts the number of pulses received. The pulse accumulator 104 provides a count of the total number of pulses to software layers represented generally at 106. Embedded within the software layers is an international configuration layer 108 and a meter calculations layer 110. The international configuration layer 108 performs operations necessary in order to convert pulse accumulator input into a form compatible with the meter calculations layer 110 software.

More particularly, if the meter calculations layer 110 software was implemented strictly for the domestic U.S. market, such software may not be compatible for the international meter measurements made. By converting the input in the international configuration layer 108 to a form compatible with such meter configuration layer 110 software, the need to rewrite the entire meter calculation layer 110 software is eliminated. Otherwise, the costly and time consuming task of rewriting the meter calculations layer 110 must be performed.

Output from the software layers 106 is provided to a display output 112 such as a liquid crystal display (LCD).

Although illustrated as being implemented in software, it is contemplated that many of the operations hereinafter described may be implemented in hardware, or in some hardware/software combination.

Details with regard to pulse generators, pulse accumulation, meter calculations and displays are set forth in the "Handbook For Electricity Metering", Eight Edition, Edison Electric Institute, 1111 19th Street, N.W., Washington, D.C. 20036 (1981).

Specifically with regard to the International configuration operations, for U.S. domestic meter registers, a meter constant K is defined as follows:

$$K = [ K_h \times (R/P) \times S_f \times T_f ] / K_r \qquad (1)$$

where,

$K_h$ = meter watthour constant (watthours/meter disk revolution);

$S_f$ = scale factor (integer in the range of 1-10);

$T_f$ = transformer factor = voltage transformer ratio x current transformer ratio;

R/P = meter disk revolutions/optics output pulse; and

$K_r$ = register display multiplier.

Scale factor $S_f$ is provided for those situation where a demand interval is long (sixty or more minutes) and the meter operates at high loads and therefore produces pulses at a high rate. This combination could result in an overflow of the demand counter. A programming operator should recognize such a possibility and select a suitable value for $S_f$ to prevent such overflow. The incoming pulses are divided by $S_f$ before accumulation in a demand counter. In most cases, however, $S_f$ is set to equal one.

Transformer factor $T_f$ is provided for transformer rated meters. Multiplying $K_h$ by $T_f$ results in a quantity $PK_h$ (primary watthour constant) - the watthours in the primary circuit/meter disk revolution. For self-contained (direct- connected) meters, $T_f$ equals one.

R/P is the meter disk revolutions/optics output pulse. The ratio is determined by the design of the shutter on the meter shaft and typically is 1/12, for example, for meters manufactured by General Electric Company.

$K_r$ is provided to allow for a register display multiplier and is typically used with transformer rated meters where the energy actually being metered on the primary side of the instrument transformers is larger than the meter register can readily display. For self-contained (direct-connected) meters, $K_r$ equals one.

Three options basically are available for transformer rated meters and involve selections of $T_f$ and $K_r$. These options are:

1. If $K_r$ is set equal to one and $T_f$ is used in equation (1), the meter reads directly the energy in the primary circuit of the instrument transformers. The practical problems here are that the value of K may become very large and therefore the register display increments very rapidly and may overflow between monthly readings;

2. If $K_r$ is made equal to $T_f$, the transformer rated meter appears like a self-contained meter and reads the scaled down energy at the secondary circuit of the instrument transformers. To obtain the true energy, the meter readings must be multiplied by the transformer factor and the display multiplier $K_r$ is set to equal $T_f$; and

3. Option 2 above may result in a display multiplier such as 800 or 1200 which involves the user in some mental agility. Many users prefer the display multiplier to be a power of ten, i.e., 10, 100, 1000. In this case, $K_r$ is chosen to be the desired value and used in equation (1).

All three options can be said to be "primary reading" but the first option would be a "primary reading" without the use of multipliers.

In addition to calculating and storing K, the programming operation stores a number of other constants such a $S_f$ and $T_f$. However, only $S_f$ is actually used in the register calculation operation. The other constants are only stored for record and display purposes.

For the international market, the international meters are built to IEC 521 standards and utilize a different meter constant, $C_z$, defined as the number of meter disk revolutions per kilowatt - hour.

The relationship between $K_h$ and $C_z$ is:

$$K_h = 1000 / C_z. \quad (2)$$

Substituting in equation (1) provides:

$$K = [ 1000 \times (R/P) \times S_f \times T_f ] / [ C_z \times K_r ]. \quad (3)$$

Substituting in the value of 12 for P/R provides:

$$K = [ 1000 \times S_f \times T_f ] / [ 12 \times C_z \times K_r ]. \quad (4)$$

Typically, for U.S. domestic meters, the constant K is stored in the meter register as a six-digit constant with a decimal point between digits three and four (i.e., XXX.xxx), which provides a range of 000.001 to 999.999. It has been found, however, that when $C_z$ is used in the determination of K, accuracy is lost if K is simply stored and used as a six digit constant.

As an example of use of the foregoing equations, consider the following examples which illustrate potential problems in using the international constant $C_z$ in a domestic U.S. meter register which typically utilizes the constant K in its meter calculations.

EXAMPLE 1:

Assume $C_z$ is set to equal sixty revolutions per kilowatt - hour. Then:

$$K = 1000 / [ C_z \times 12 ], \quad (5)$$

$$K = 1000 / [ 60 \times 12 ], \text{ and} \quad (6)$$

$$K = 1.388888889 \quad (7)$$

The constant K is stored as XXX.xxx in the register, which means that for the above example, 001.388 will be stored in the register for K. If 999,999 pulses are accumulated, then:

kWh = 999,999 x [ 001.388 / 1000 ] = 1387.9986 (rounded to 1387).     (8)

On the other hand, if the constant $C_z$ is stored and directly used in the register to determine kWh, it will yield the following result:

kWh = # of pulses / [ 12 x $C_z$ ] = 999,999 / [ 12 x 60 ], and     (9)

kWh = 999,999 / 720 = 1388.8875 (rounded to 1388).     (10)

From the foregoing, it should be apparent that by using the value for the constant K, a one kWh difference results as compared to when the constant $C_z$ is used.

EXAMPLE 2:

Set $C_z$ equal to 15,000 revolutions per kWh. Then:

K = 1000 / [ $C_z$ x 12 ],     (11)

K = 1000 / [ 15,000 x 12 ], and     (12)

K = 0.00555555....     (13)

Only 000.005 will be stored in the register for K. This not only may introduce errors in a kWh calculation, but also create difficulties for a programmer/reader to display the $C_z$ value. Particularly, if a value of 000.005 is stored for K, recalculation of $C_z$ provides:

$C_z$ = [ 1000 / K ] / 12,     (14)

$C_z$ = [ 1000 / 0.005] / 12,     (15)

$C_z$ = 16666.667.     (16)

$C_z$, however, was initially set to equal 15,000.

From the foregoing examples, it can be seen that potential problems exist by simply storing a value for $C_z$ and/or K in the meter register.

To overcome these problems, it is preferred to store a ratio (integer/integer) for performing the correct kW and kWh calculations using $C_z$ in a meter register. More particularly, using a ratio X/Y, the following equation can be utilized:

kWh = [# of pulses) [X/Y], and     (17)

kW = [kWh] [ 60 / # of intervals ].     (18)

The ratio X/Y is kilowatt-hour per pulse. The ratio preferably is in the form of "integer / integer" and is factored out by a programmer/reader before storing.

Figure 2 is a flow chart 150 illustrating a sequence of process steps for identifying the values for X and Y. More particularly, after starting operations as indicated by a "START" legend 152, values for R/P, $S_f$, $T_f$, $C_z$, and $K_r$ are input to the register as indicated at 154. X and Y are then calculated, as indicated at 156, as follows:

X = R $S_f$ $T_f$, and     (19)

Y = P $C_z$ $K_r$.     (20)

These values for X and Y are then factored out by the Greatest Common Diviser (GCD) and stored in the meter register and used, when required, for meter register calculations.

Accuracy is retained by utilizing the present invention in meter registers which must utilize the international constant $C_z$ but are based on U.S. domestic algorithms.

While the present invention has been described with respect to specific embodiments, many modifications, variations, substitutions, and equivalents will be apparent to those skilled in the art. Accordingly, the invention is to be considered as limited only by the spirit and scope of the appended claims.

**Claims**

1. A method comprising the steps of:
   representing a meter constant as a ratio of two integers, at least one of the integers being derived, at least in part, by a meter constant $C_z$; and
   using the ratio to derive a meter measurement of a quantum of energy consumed.

2. A method in accordance with Claim 1 wherein the meter measurement derived using the ratio is kilowatt-hours (kWh).

3. A method in accordance with Claim 1 wherein the ratio is defined as X/Y where:

   X = R $S_f$ $T_f$, and
   Y = P $C_z$ $K_r$,

   where:
   $S_f$ =     scale factor (integer in the range of 1- 10);
   $T_f$ =     transformer factor = voltage transformer ratio x current transformer ratio;
   $C_z$ =     international meter constant defined by system operator;

R/P = meter disk revolutions/optics output pulse; and

$K_r$ = register display multiplier.

4. A method in accordance with Claim 1 wherein each of said steps is implemented in software.

5. A method of controlling a microprocessor to perform the steps of:

representing a meter constant as a ratio of two integers, at least one of the integers being derived, at least in part, by a meter constant $C_z$; and

using the ratio to derive a meter measurement of a quantum of energy consumed.

6. A method in accordance with Claim 5 wherein the meter measurement derived using the ratio is kilowatt-hours (kWh).

7. A method in accordance with Claim 5 wherein the ratio is defined as X/Y where:

$X = R\, S_f\, T_f$, and
$Y = P\, C_z\, K_r$,

where:

$S_f$ = scale factor (integer in the range of 1- 10);

$T_f$ = transformer factor = voltage transformer ratio x current transformer ratio;

$C_z$ = international meter constant defined by system operator;

R/P = meter disk revolutions/optics output pulse; and

$K_r$ = register display multiplier.

8. An apparatus, comprising:

means for representing a meter constant as a ratio of two integers, at least one of the integers being derived, at least in part, by a meter constant $C_z$; and

means for using the ratio to derive a meter measurement of a quantum of energy consumed.

9. An apparatus in accordance with Claim 8 wherein the meter measurement derived using the ratio is kilowatt-hours (kWh).

10. An apparatus in accordance with Claim 8 wherein the ratio is defined as X/Y where:

$X = R\, S_f\, T_f$, and
$Y = P\, C_z\, K_r$,

where:

$S_f$ = scale factor (integer in the range of 1- 10);

$T_f$ = transformer factor = voltage transformer ratio x current transformer ratio;

$C_z$ = international meter constant defined by system operator;

R/P = meter disk revolutions/optics output pulse; and

$K_r$ = register display multiplier.

*100*  *102*

INPUT FROM METER

*104*

PULSE ACCUMULATOR

*108*
*106*

INTERNATIONAL
CONFIGURATION LAYER

METER CALCULATIONS
LAYER

*110*

*112*

DISPLAY OUTPUT

**FIG.1**

*152*  *150*

START

*154*

INPUT VALUES FOR R/P,
$S_f$, $T_f$, $C_z$ AND $K_r$

*156*

CALCULATE:

$X = R \ S_f \ T_f$

$Y = P \ C_z \ K_r$

*158*

STORE X AND Y
(FACTORED BY GREATEST
COMMON DIVISOR)

*160*

END

**FIG.2**

## DOCUMENTS CONSIDERED TO BE RELEVANT

EP 92300614.2

| Category | Citation of document with indication, where appropriate, of relevant passages | Relevant to claim | CLASSIFICATION OF THE APPLICATION (Int. Cl.5) |
|---|---|---|---|
| A | DD - A - 58 703 (SCHEIBE) * Page 1 * | 1 | G 01 R 11/57 |
| A | DE - A - 2 636 912 (SIEMENS) * Claim 1 * | 1 | |
| A | DE - B - 1 295 210 (HOFFMANN) * Claim 1 * | 1 | |

TECHNICAL FIELDS SEARCHED (Int. Cl.5)

G 01 R 11/00
G 01 R 21/00

The present search report has been drawn up for all claims

| Place of search | Date of completion of the search | Examiner |
|---|---|---|
| VIENNA | 10-12-1992 | KUNZE |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
 
& : member of the same patent family, corresponding
document

EPO FORM 1503 03.82 (P0401)